# EUROPEAN PATENT SPECIFICATION

(11) **EP 4 266 136 B1**
(45) Date of publication and mention of the grant of the patent: **25.11.2026**
(21) Application number: 22748978.8
(22) Date of filing: 26.01.2022
(51) Int. Cl.: G05B 19/042

(54) **CONTROL SYSTEM FOR ELECTRIC LIFTING DESK, AND ELECTRIC LIFTING DESK**
STEUERUNGSSYSTEM FÜR ELEKTRISCHEN HUBTISCH UND ELEKTRISCHER HUBTISCH
SYSTÈME DE COMMANDE POUR BUREAU À LEVAGE ÉLECTRIQUE, ET BUREAU À LEVAGE ÉLECTRIQUE

(30) Priority: 08.02.2021 CN 202110172287
(43) Date of publication of application: 25.10.2023
(73) Proprietor: DewertOkin Technology Group Co., Ltd., Jiaxing City, Zhejiang Province 314011 (CN)
(72) Inventor: LI, Long, Jiaxing, Zhejiang 314011 (CN); LIU, Hui, Jiaxing, Zhejiang 314011 (CN)
(74) Representative: Grünecker Patent- und Rechtsanwälte PartG mbB
(86) International application number: PCT/CN2022/073948
(87) International publication number: WO 2022/166699

(56) References cited:
- EP-A1- 3 226 721
- WO-A1-2018/214194
- CN-A- 104 460 697
- CN-A- 106 249 645
- CN-A- 110 262 332
- CN-A- 110 501 924
- CN-A- 113 009 860
- CN-A- 113 917 367
- CN-U- 203 489 891

## Description

The present application relates to the technical field of electric lifting desks, for example, a control system for an electric lifting desk and an electric lifting desk.

As social electronic technologies develop, various kinds of smart furniture have been increasingly chosen and used by users. Electric lifting desks are widely used as a type of smart furniture. With the increasing popularity of electric lifting desks, customization requirements of customers are also different. For an electrical lifting desk, some customers require a single column, some customers require two columns, some customers require three columns, etc. Requirements for the column type are also different, some customers require two-section columns, some customers require three-section columns, etc. For these different requirements, a common approach is to provide controllers with different serial numbers and corresponding to different software, resulting in a wide variety of controllers and increasing management and inventory costs.

Conventional approaches for controlling electric lifting desks are described in CN 106 249 645 A, CN 110 501 924 A, and WO 2018/214194 A1.

The present application provides a control system for an electric lifting desk and an electric lifting desk, so that the connection manner between a controller and a to-be-controlled column is improved, the determination of the number of columns and the column type by the controller is achieved, and thus the management costs are reduced.

This is achieved by the features of independent claim 1. Further features and advantages of the present invention are set forth in dependent claims.
FIG. 1 is a structural diagram of a control system for an electric lifting desk according to an embodiment of the present application;
FIG. 2 is a circuit connection diagram of a control system for an electric lifting desk according to an embodiment of the present application;
FIG. 3 is an equivalent circuit diagram of a control system for an electric lifting desk according to an embodiment of the present application; and
FIG. 4 is a structural diagram of an electric lifting desk according to an embodiment of the present application.

The technical scheme of the present application is described hereinafter through implementations in conjunction with the drawings in embodiments of the present application. The described embodiments are part of embodiments of the present application.

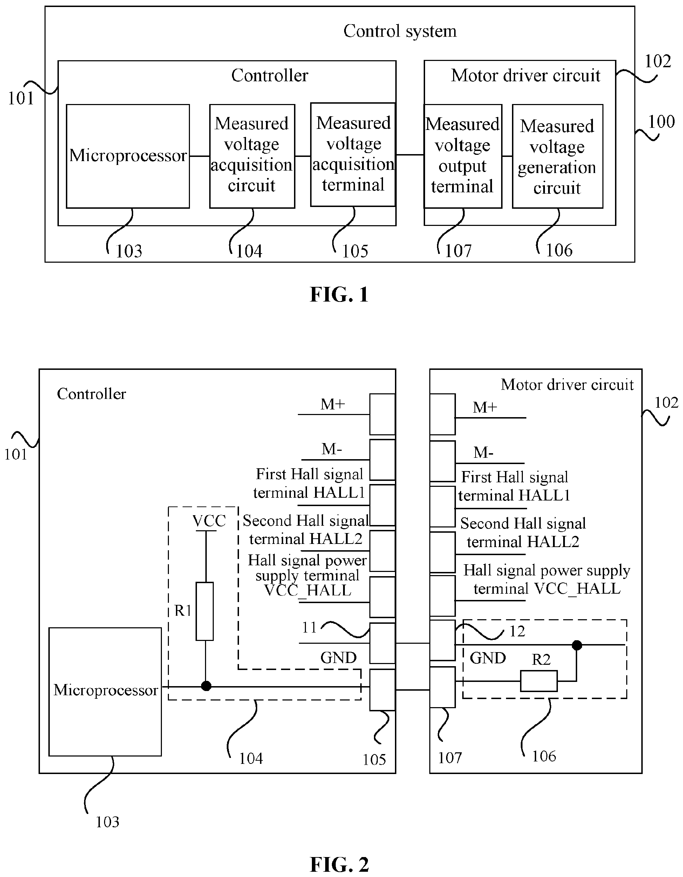

FIG. 1 is a structural diagram of a control system for an electric lifting desk according to an embodiment of the present application. As shown in FIG. 1, the control system 100 includes a controller 101 and a motor driver circuit 102. The controller 101 includes a microprocessor 103, a measured voltage acquisition circuit 104 and a measured voltage acquisition terminal 105. The input and the output of the measured voltage acquisition 104 are connected to the measured voltage acquisition terminal 105 and the microprocessor 103, respectively. The motor driver circuit 102 is configured to drive the lifting of at least one column. The motor driver circuit includes a measured voltage generation circuit 106 and a measured voltage output terminal 107, and the output of the measured voltage generation circuit 106 is electrically connected to the measured voltage output terminal 107. When the number of columns and/or the column type of the electric lifting desk is different, the value of the measured voltage output by the measured voltage generation circuit 106 is different. The measured voltage acquisition terminal 105 is electrically connected to the measured voltage output terminal 107; the microprocessor 103 is configured to determine whether the controller 101 is connected to the motor driver circuit 102 according to the voltage signal provided by the measured voltage acquisition circuit 104, and the microprocessor 103 is also configured to determine the number of columns and/or the column type of the electric lifting desk.

The microprocessor 103 may be a single-chip computer inside the controller 101 and is configured to perform analysis and processing on the voltage signal provided by the measured voltage acquisition circuit 104, determine a connection relationship between the motor driver circuit 102 and the controller 101, and then determine the number and/or the type of columns driven by the motor driver circuit 102 through different measured voltages provided by the motor driver circuit and corresponding to different numbers of columns and/or different column types. A port where the microprocessor 103 is electrically connected to the measured voltage acquisition circuit 104 is a digital-to-analog conversion port. The digital-to-analog conversion port is configured to convert a received voltage signal into a digital signal so that the microprocessor 103 performs the analysis, processing and determination on the digital signal to determine the measured voltage provided by the measured voltage generation circuit 106 of the motor driver circuit 102, and thus the number of columns and/or the column type corresponding to the connected motor driver circuit 102 can be determined according to different measured voltages. Multiple measured voltage acquisition terminals 105 and multiple measured voltage output terminals 107 may both be provided. Multiple measured voltage acquisition terminals 105 and multiple measured voltage output terminals 107 are electrically connected in one-to-one correspondence. The measured voltage acquisition terminal 105 and the measured voltage output terminal 107 may be set according to actual requirements.

The control system 100 provided in the embodiment of the present application includes a controller 101 and at least one motor driver circuit 102. At least one hole is provided on the controller 101, a column is mounted in each hole, and each motor driver circuit 102 is disposed in the column. That is, the number of motor driver circuits 102 is the same as the number of holes in the control system 100, the at least one motor driver circuit 102 and the at least one hole are in one-to-one correspondence. Each motor driver circuit 102 is configured to drive a column, when this column where the motor driver circuit 102 is located is mounted in the hole. When a column is mounted in a hole of the controller 101, the controller 101 forms a circuit with the motor driver circuit 102 of this column so that a corresponding equivalent resistance value exists in the motor drive circuit 102 of the column. Therefore, whether a column is mounted in a hole of the controller 101 may be determined according to the equivalent resistance value of the motor driver circuit 102.

The number of measured voltage acquisition circuits 104 and the number of measured voltage acquisition terminals 105 in the controller 101 are both the same as the number of holes provided on the controller 101, at least one measured voltage acquisition circuit 104 is connected to at least one measured voltage acquisition terminal 105 in one-to-one correspondence, and the at least one measured voltage acquisition terminal 105 and at least one hole are in one-to-one correspondence. Each measured voltage acquisition terminal 105 is configured to be connected to a motor driver circuit 102 of a column, when the column is mounted in the hole corresponding to the measured voltage acquisition terminal 105. The microprocessor 103 is configured to determine whether a measured voltage acquisition terminal 105 connected to each measured voltage acquisition circuit 104 is connected to the motor driver circuit 102 according to the voltage signal provided by each measured voltage acquisition circuit 104, and then determine whether a column is mounted in the hole corresponding to the measured voltage acquisition terminal 105. When it is determined that a column is mounted in the hole corresponding to the measured voltage acquisition terminal 105, the microprocessor 103 may also determine the column type according to the equivalent resistance value.

FIG 1 is only a structural diagram showing the connection between a motor driver circuit 102 and a group of the measured voltage acquisition circuit 104 and the measured voltage acquisition terminal 105 in the controller 101. The structural diagram shown in FIG. 1 is used for determining whether a column is mounted in a hole on the control system 100, and also used for determining the column type if the column is mounted in the hole.

FIG. 2 is a circuit connection diagram of a control system for an electric lifting desk according to an embodiment of the present application. As shown in FIG. 2, optionally, the measured voltage acquisition circuit 104 includes a first resistor R1, a first end of the first resistor R1 is electrically connected to a power supply voltage terminal VCC, and a second end of the first resistor R1 is electrically connected to both the measured voltage acquisition terminal 105 and the microprocessor 103.

Optionally, the controller 101 also includes a first ground terminal 11, the motor driver circuit 102 also includes a second ground terminal 12, and the second ground terminal 12 is connected to the first ground terminal 11. The measured voltage generation circuit 106 includes a second resistor R2, a first end of the second resistor R2 is electrically connected to the second ground terminal, and a second end of the second resistor R2 is electrically connected to the measured voltage output terminal 107.

The resistance value of the second resistor R2 corresponds to both the number of columns and the column type.

Optionally, the resistance value of the first resistor R1 is the same as or different from the resistance value of the second resistor R2.

With continued reference to FIG. 2, the resistance value of the first resistor R1 is fixed. For example, the resistance value of the first resistor R1 may be 10K, 20K, etc. In the measurement process, the resistance value of the first resistor R1 is set to a fixed value, which can facilitate the microprocessor 103 executing its function and ensure the accuracy of the measurement result. The first end of the second resistor R2 is electrically connected to the second ground terminal 12, and the second end of the second resistor R2 is electrically connected to the measured voltage output terminal 107. The controller 101 also includes the first ground terminal 11. The first ground terminal 11 is electrically connected to the second ground terminal 12, and both the first ground terminal 11 and the second ground terminal 12 are connected to a ground terminal GND. The second resistor R2 may be set according to different column types, and resistance values of the second resistor R2 corresponding to different column types are different, ensuring the accuracy of the determination result of the microprocessor 103. The resistance value of the first resistor R1 may be the same as or different from the resistance value of the second resistor R2, and the accuracy of the measurement result can be ensured in both two cases.

Optionally, the microprocessor 103 is configured to compare the voltage signal provided by the measured voltage acquisition circuit 104 with a power supply voltage signal, and when the voltage signal provided by the measured voltage acquisition circuit 104 is equal to the power supply voltage signal, the microprocessor 103 is configured to determine that the controller 101 is disconnected from the motor driver circuit 102, and when the voltage signal provided by the measured voltage acquisition circuit 104 is less than the power supply voltage signal, the microprocessor 103 is configured to determine that the controller 101 is connected to the motor driver circuit 102.

Similar to FIG. 1, FIG. 2 only shows a diagram of the circuit connection between a motor driver circuit 102 and a group of the measured voltage acquisition circuit 104 and the measured voltage acquisition terminal 105 in the controller 101. The resistance value of the second resistor R2 is the equivalent resistance value in the motor driver circuit 102. The resistance value of the second resistor R2 corresponding to both the number of columns and the column type refers to that whether a column where the motor driver circuit 102 is located is mounted in a hole may be determined according to the resistance value of the second resistor R2, and that the column type may be determined according to the resistance value of the second resistor R2 when the column where the motor driver circuit 102 is located is mounted in the hole. In the embodiment, the resistance value of the second resistor R2 varies due to whether the column is mounted and the mounted-column type.

The controller 101 being disconnected from the motor driver circuit 102 actually refers to that no column is mounted in the corresponding hole of the controller 101, which is equivalent to an infinite resistance value corresponding to the second resistor R2. The controller 101 being connected to the motor driver circuit 102 actually refers to that a column is mounted in the corresponding hole of the controller 101, that is, in FIG. 2, the resistance value corresponding to the second resistor R2 corresponds to the column type.

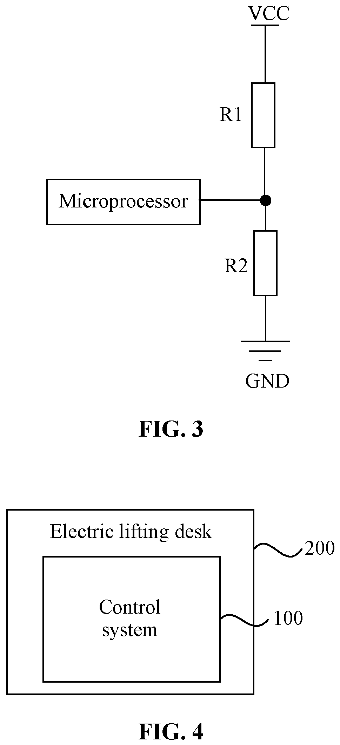

FIG. 3 is an equivalent circuit diagram of a control system for an electric lifting desk according to an embodiment of the present application. The measured voltage generation circuit 106 is determined by the second resistor R2. Since the measured voltage acquisition terminal 105 is electrically connected to the measured voltage output terminal 107, the measured voltage output terminal 107 outputs a voltage signal corresponding to the second resistor R2, the measured voltage acquisition terminal 105 receives the voltage signal corresponding to the second resistor R2 and output by the measured voltage output terminal 107, and the microprocessor 103 receives the voltage signal corresponding to the second resistor R2 and a voltage signal corresponding to the first resistor R1. As shown in FIG. 3, the first resistor R1 is connected in parallel with the second resistor R2. When the controller 101 is disconnected from the motor driver circuit 102, the voltage signal corresponding to the second resistor R2 is infinite. At this time, the voltage signal received by the microprocessor 103 is equal to the power supply voltage, that is, the measured voltage output terminal 107 of the motor driver circuit 102 is not connected to the column. When the controller 101 is connected to the motor driver circuit 102, the first resistor R1 and the second resistor R2 connected in parallel have the voltage division function. At this time, the voltage signal received by the microprocessor 103 is less than the power supply voltage, that is, the measured voltage output terminal 107 of the motor driver circuit 102 is connected to a column.

The number of columns is greater than zero; and optionally the column type includes at least one of a two-section column or a three-section column.

The number of columns of the control system 100 may be set according to actual requirements. The number of columns may include one, two, three, four, etc. The number of columns connected to the measured voltage output terminal 107 of the motor driver circuit 102 may be determined as zero. The column type may include a two-section column and a three-section column. For example, it may be set that the resistance value of the second resistor R2 corresponding to the two-section column is 10K, and the resistance value of the second resistor R2 corresponding to the three-section column is 20K. The corresponding number of columns may be determined in combination with the column type according to requirements.

Optionally, the power supply voltage VCC is 3.3 V, 5 V or 12 V.

The voltage value of the power supply voltage VCC is generally the same as the power supply voltage of the microprocessor 103 in the controller 101, reducing the set external power supply type and the cost.

The microprocessor 103 is also configured to, when the voltage signal provided by the measured voltage acquisition circuit 104 is less than the power supply voltage signal, determine the resistance value of the second resistor R2 according to a voltage signal calculation formula that V = VCC*R2/(R1+R2) and a known resistance value of the first resistor R1, and then determine the number of columns and/or the column type of the electric lifting desk according to a correspondence between the resistance value of the second resistor R2 and the number of columns and/or the column type.

With continued reference to FIG. 2 and FIG. 3, different column types correspond to different resistance values of the second resistance R2, therefore, the microprocessor 103 may perform analysis according to different received voltage signals and determine the column type in combination with voltage signal values that correspond to different column types and are preset in the microprocessor 103. When the resistance value of the first resistor R1 is 10K, the resistance value of the second resistor R2 corresponding to the two-section column is 10K, the resistance value of the second resistor R2 corresponding to the three-section column is 20K, and the power supply voltage VCC is 5 V. When the resistance value of the second resistor R2 preset in the microprocessor 103 is 10K, the corresponding voltage signal value provided by the measured voltage acquisition circuit 104 is 2.5 V; and when the resistance value of the second resistor R2 is 20K, the corresponding voltage signal value provided by the measured voltage acquisition circuit 104 is 3.33 V. When the voltage signal V received by the microprocessor 103 and provided by the measured voltage acquisition circuit 104 satisfies that V = 5*20/(10+20) = 3.33 V, it may be determined that the measured voltage output terminal 107 of the motor driver circuit 102 is electrically connected to a column, and the column type is a three-section column.

Optionally, the controller 101 also includes a forward rotation voltage terminal M+, a reverse rotation voltage terminal M-, a Hall signal terminal HALL and a Hall signal power supply terminal VCC_HALL. The forward rotation voltage terminal M+ is configured to transmit a forward rotation signal for controlling a motor electrically connected to the motor driver circuit 102; the reverse rotation voltage terminal M- is configured to transmit a reverse rotation signal for controlling the motor electrically connected to the motor driver circuit 102; the Hall signal terminal HALL is configured to transmit a rotor position signal of the motor; and the Hall signal power supply terminal VCC_HALL is configured to connect to an external device for supplying power to a Hall sensor inside the motor.

With continued reference to FIG. 2, to correspond to the controller 101, a forward rotation voltage terminal M+, a reverse rotation voltage terminal M-, a first Hall signal terminal HALL1, a second Hall signal terminal HALL2 and a Hall signal power supply terminal VCC_HALL are also disposed in the motor driver circuit 102, and ports of the same type in the controller 101 and the motor driver circuit 102 are in one-to-one correspondence. In this manner, the correct and orderly transmission of multiple signals is ensured, which facilitates the controller 101 outputting a control signal for controlling the operation of the motor driver circuit 102 and thus adjusting the lifting of the column.

The present application provides a control system for an electric lifting desk and an electric lifting desk. The electric lifting desk includes at least one column, the control system includes a controller and a motor driver circuit, and the control includes a microprocessor, a measured voltage acquisition circuit and a measured voltage acquisition terminal. The motor driver circuit is configured to drive the lifting of at least one column, and the motor driver circuit includes a measured voltage generation circuit and a measured voltage output terminal. Through the signal transmission among the microprocessor, the measured voltage acquisition circuit, the measured voltage acquisition terminal, the measured voltage generation circuit and the measured voltage output terminal, whether the controller is connected to the motor driver circuit is determined, and the number of columns and/or the column type is determined. The connection relationship between the controller and the column is improved, the accurate determination of the number of columns and/or the column type by the controller is achieved, and thus the management cost is reduced.

Based on the same concept, the present application also provides an electric lifting desk. FIG. 4 is a structural diagram of an electric lifting desk according to an embodiment of the present application. The electric lifting desk 200 includes the control system 100 in any one of the preceding embodiments and at least one column.

The electric lifting desk provided in the embodiment has the same or corresponding effects as any one of the preceding control systems, which will not be repeated here.

## Claims

1. A control system (100) for an electric lifting desk, wherein the electric lifting desk comprises at least one column, and the control system (100) comprises:
a controller (101), wherein the controller (101) comprises a microprocessor (103), at least one measured voltage acquisition circuit (104) and at least one measured voltage acquisition terminal (105), wherein an input of each of the at least one measured voltage acquisition circuit (104) and an output of each of the at least one measured voltage acquisition circuit (104) are connected to a respective measured voltage acquisition terminal (105) and the microprocessor (103), respectively;
**characterized in that**
each of the at least one column comprises a motor driver circuit (102) configured to drive lifting of the respective column, wherein
the motor driver circuit (102) comprises a measured voltage generation circuit (106) and a measured voltage output terminal (107);
an output of the measured voltage generation circuit (106) is electrically connected to the measured voltage output terminal (107);
the measured voltage generation circuit (106) is configured to output a different value of a measured voltage in a case of at least one of a different number of columns of the electric lifting desk or a different column type of the electric lifting desk;
each of the at least one measured voltage acquisition terminals (105) is adapted to be electrically connected to a respective measured voltage output terminal (107); and
the microprocessor (103) is configured to determine, according to a voltage signal provided by each of the at least one measured voltage acquisition circuit (104), whether the controller (101) is connected to respective at least one of the motor driver circuit (102) to determine at least one of a number of columns of the electric lifting desk or a column type of the electric lifting desk; wherein
the measured voltage acquisition circuit (104) comprises a first resistor (R1), a first end of the first resistor (R1) is configured to be electrically connected to a power supply voltage terminal (VCC), and a second end of the first resistor (R1) is electrically connected to both the respective measured voltage acquisition terminal (105) and the microprocessor (103);
the controller (101) further comprises a first ground terminal (11), the motor driver circuit (102) further comprises a second ground terminal (12), and the second ground terminal (12) is connected to the first ground terminal (11);
the measured voltage generation circuit (106) comprises a second resistor (R2), a first end of the second resistor (R2) is electrically connected to the second ground terminal (12), and a second end of the second resistor R2 is electrically connected to the measured voltage output terminal (107); and
a resistance value of the second resistor (R2) corresponds to both the number of columns of the electric lifting desk and the column type of the electric lifting desk.

2. The control system (100) according to claim 1, wherein the microprocessor (103) is configured to determine, according to the voltage signal provided by a measured voltage acquisition circuit (104), whether the controller (101) is connected to the respective motor driver circuit (102) in the following manner:
comparing the voltage signal provided by the measured voltage acquisition circuit (104) with a power supply voltage signal;
determining that the controller (101) is disconnected from the motor driver circuit (102), when the voltage signal provided by the measured voltage acquisition circuit (104) is equal to the power supply voltage signal; and
determining that the controller (101) is connected to the motor driver circuit (102), when the voltage signal provided by the measured voltage acquisition circuit (104) is less than the power supply voltage signal.

3. The control system (100) according to claim 2, wherein the microprocessor (103) is configured to determine at least one of the number of columns of the electric lifting desk or the column type of the electric lifting desk in the following manner:
determining the resistance value of the second resistor (R2) according to a known resistance value of the first resistor (R1) and a voltage signal calculation formula that V = VCC*R2/(R1+R2), when the voltage signal provided by a measured voltage acquisition circuit (104) is less than the power supply voltage signal; and
determining, according to a correspondence between the resistance value of the second resistor (R2) and the at least one of the number of columns or the column type, the at least one of the number of columns of the electric lifting desk or the column type of the electric lifting desk.

4. The control system (100) according to any of claims 1 to 3, wherein a resistance value of the first resistor (R1) is the same as or different from the resistance value of the second resistor (R2).

5. The control system (100) according to any of claims 1 to 4, wherein the power supply voltage VCC is 3.3 V, 5 V or 12 V.

6. The control system (100) according to any of claims 1 to 5, wherein the number of columns is larger than zero; and the column type comprises a two-section column and a three-section column.

7. The control system (100) according to any of claims 1 to 6, wherein the controller (101) further comprises a forward rotation voltage terminal (M+), a reverse rotation voltage terminal (M-), a Hall signal terminal (HALL) and a Hall signal power supply terminal (VCC_HALL); and
the forward rotation voltage terminal (M+) is configured to transmit a forward rotation signal for controlling a motor electrically connected to a motor driver circuit (102);
the reverse rotation voltage terminal (M-) is configured to transmit a reverse rotation signal for controlling the motor electrically connected to a motor driver circuit (102);
the Hall signal terminal (HALL) is configured to transmit a rotor position signal of the motor; and
the Hall signal power supply terminal (VCC_HALL) is configured to connect to an external device for supplying power to a Hall sensor inside the motor.

8. An electric lifting desk (200), comprising
at least one column; and
the control system (100) according to any one of claims 1 to 7.

## Patentansprüche

1. Steuerungssystem (100) für einen elektrischen Hebeschreibtisch, wobei der elektrische Hebeschreibtisch mindestens eine Säule umfasst und das Steuerungssystem (100) Folgendes umfasst:
eine Steuerung (101), wobei die Steuerung (101) einen Mikroprozessor (103), mindestens eine Messspannungserfassungsschaltung (104) und mindestens einen Messspannungserfassungsanschluss (105) umfasst, wobei ein Eingang der jeweils mindestens einen Messspannungserfassungsschaltung (104) und ein Ausgang der jeweils mindestens einen Messspannungserfassungsschaltung (104) mit einem jeweiligen Messspannungserfassungsanschluss (105) beziehungsweise dem Mikroprozessor (103) verbunden sind,
**dadurch gekennzeichnet, dass**
die jeweils mindestens eine Säule eine Motoransteuerschaltung (102) umfasst, die konfiguriert ist, um ein Heben der jeweiligen Säule anzusteuern, wobei
die Motoransteuerschaltung (102) eine Messspannungserzeugungsschaltung (106) und einen Messspannungsausgangsanschluss (107) umfasst;
ein Ausgang der Messspannungserzeugungsschaltung (106) elektrisch mit dem Messspannungsausgangsanschluss (107) verbunden ist;
die Messspannungserzeugungsschaltung (106) konfiguriert ist, um einen unterschiedlichen Wert einer Messspannung auszugeben, wenn mindestens eines der folgenden Merkmale unterschiedlich ist: eine Anzahl von Säulen des elektrischen Hebeschreibtischs oder eine Säulenart des elektrischen Hebeschreibtischs;
der jeweils mindestens eine Messspannungserfassungsanschluss (105) ausgelegt ist, um elektrisch mit einem jeweiligen Messspannungsausgangsanschluss (107) verbunden zu werden, und
der Mikroprozessor (103) konfiguriert ist, um gemäß einem durch die jeweils mindestens eine Messspannungserfassungsschaltung (104) bereitgestellten Spannungssignal zu bestimmen, ob die Steuerung (101) mit der jeweils mindestens einen Motoransteuerschaltung (102) verbunden ist, um mindestens eines der folgenden Merkmale zu bestimmen: eine Anzahl von Säulen des elektrischen Hebeschreibtischs oder eine Säulenart des elektrischen Hebeschreibtischs, wobei
die Messspannungserfassungsschaltung (104) einen ersten Widerstand (R1) umfasst, ein erstes Ende des ersten Widerstands (R1) konfiguriert ist, um elektrisch mit einem Stromversorgungsspannungsanschluss (VCC) verbunden zu werden, und ein zweites Ende des ersten Widerstands (R1) elektrisch sowohl mit dem jeweiligen Messspannungserfassungsanschluss (105) als auch dem Mikroprozessor (103) verbunden ist;
die Steuerung (101) ferner einen ersten Masseanschluss (11) umfasst, die Motoransteuerschaltung (102) ferner einen zweiten Masseanschluss (12) umfasst und der zweite Masseanschluss (12) mit dem ersten Masseanschluss (11) verbunden ist;
die Messspannungserzeugungsschaltung (106) einen zweiten Widerstand (R2) umfasst, ein erstes Ende des zweiten Widerstands (R2) elektrisch mit dem zweiten Masseanschluss (12) verbunden ist und ein zweites Ende des zweiten Widerstands (R2) elektrisch mit dem Messspannungsausgangsanschluss (107) verbunden ist, und wobei
ein Widerstandswert des zweiten Widerstands (R2) sowohl der Anzahl von Säulen des elektrischen Hebeschreibtischs als auch der Säulenart des elektrischen Hebeschreibtischs entspricht.

2. Steuerungssystem (100) nach Anspruch 1, wobei der Mikroprozessor (103) konfiguriert ist, um gemäß dem durch die Messspannungserfassungsschaltung (104) bereitgestellten Spannungssignal auf folgende Weise zu bestimmen, ob die Steuerung (101) mit der jeweiligen Motoransteuerschaltung (102) verbunden ist:
Vergleichen des durch die Messspannungserfassungsschaltung (104) bereitgestellten Spannungssignals mit einem Stromversorgungsspannungssignal;
Bestimmen, dass die Steuerung (101) von der Motoransteuerschaltung (102) getrennt ist, wenn das durch die Messspannungserfassungsschaltung (104) bereitgestellte Spannungssignal gleich dem Stromversorgungsspannungssignal ist, und
Bestimmen, dass die Steuerung (101) mit der Motoransteuerschaltung (102) verbunden ist, wenn das durch die Messspannungserfassungsschaltung (104) bereitgestellte Spannungssignal kleiner als das Stromversorgungsspannungssignal ist.

3. Steuerungssystem (100) nach Anspruch 2, wobei der Mikroprozessor (103) konfiguriert ist, um mindestens eines der folgenden Merkmale auf folgende Weise zu bestimmen: die Anzahl von Säulen des elektrischen Hebeschreibtischs oder die Säulenart des elektrischen Hebeschreibtischs:
Bestimmen des Widerstandswerts des zweiten Widerstands (R2) gemäß einem bekannten Widerstandswert des ersten Widerstands (R1) und einer Spannungssignalberechnungsformel, wobei V = VCC*R2/(R1+R2) gilt, wenn das durch die Messspannungserfassungsschaltung (104) bereitgestellte Spannungssignal kleiner als das Stromversorgungsspannungssignal ist, und
Bestimmen mindestens eines der folgenden Merkmale: der Anzahl von Säulen des elektrischen Hebeschreibtischs oder der Säulenart des elektrischen Hebeschreibtischs gemäß einer Entsprechung zwischen dem Widerstandswert des zweiten Widerstands (R2) und mindestens einem der folgenden Merkmale: der Anzahl von Säulen oder der Säulenart.

4. Steuerungssystem (100) nach einem der Ansprüche 1 bis 3, wobei ein Widerstandswert des ersten Widerstands (R1) gleich dem Widerstandswert des zweiten Widerstands (R2) oder von diesem verschieden ist.

5. Steuerungssystem (100) nach einem der Ansprüche 1 bis 4, wobei die Stromversorgungsspannung VCC 3,3 V, 5 V oder 12 V ist.

6. Steuerungssystem (100) nach einem der Ansprüche 1 bis 5, wobei die Anzahl von Säulen größer als null ist und die Säulenart eine Säule mit zwei Abschnitten und eine Säule mit drei Abschnitten umfasst.

7. Steuerungssystem (100) nach einem der Ansprüche 1 bis 6, wobei die Steuerung (101) ferner einen Vorwärtsdrehungsspannungsanschluss (M+), einen Rückwärtsdrehungsspannungsanschluss (M-), einen Hallsignalanschluss (HALL) und einen Hallsignalstromversorgungsanschluss (VCC_HALL) umfasst und
der Vorwärtsdrehungsspannungsanschluss (M+) konfiguriert ist, um ein Vorwärtsdrehungssignal zum Steuern eines elektrisch mit einer Motoransteuerschaltung (102) verbundenen Motors zu übertragen, der Rückwärtsdrehungsspannungsanschluss (M-) konfiguriert ist, um ein Rückwärtsdrehungssignal zum Steuern des elektrisch mit einer Motoransteuerschaltung (102) verbundenen Motors zu übertragen, der Hallsignalanschluss (HALL) konfiguriert ist, um ein Rotorpositionssignal des Motors zu übertragen und
der Hallsignalstromversorgungsanschluss (VCC_HALL) konfiguriert ist, um sich mit einer externen Vorrichtung zu verbinden, um einen Hallsensor im Inneren des Motors mit Strom zu versorgen.

8. Elektrischer Hebeschreibtisch (200), umfassend
mindestens eine Säule und
das Steuerungssystem (100) nach einem der Ansprüche 1 bis 7.

## Revendications

1. Système de commande (100) pour un bureau à levage électrique, dans lequel le bureau à levage électrique comprend au moins une colonne, et le système de commande (100) comprend :
une unité de commande (101), dans lequel l'unité de commande (101) comprend un microprocesseur (103), au moins un circuit d'acquisition de tension mesurée (104) et au moins une borne d'acquisition de tension mesurée (105), dans lequel une entrée de chacun de l'au moins un circuit d'acquisition de tension mesurée (104) et une sortie de chacun de l'au moins un circuit d'acquisition de tension mesurée (104) sont connectées à une borne d'acquisition de tension mesurée (105) respective et au microprocesseur (103), respectivement ;
**caractérisé en ce que**
chacune de l'au moins une colonne comprend un circuit de pilotage de moteur (102) configuré pour piloter le levage de la colonne respective, dans lequel
le circuit de pilotage de moteur (102) comprend un circuit de génération de tension mesurée (106) et une borne de sortie de tension mesurée (107) ;
une sortie du circuit de génération de tension mesurée (106) est connectée électriquement à la borne de sortie de tension mesurée (107) ;
le circuit de génération de tension mesurée (106) est configuré pour délivrer en sortie une valeur différente d'une tension mesurée dans un cas où au moins l'un parmi un nombre différent de colonnes du bureau à levage électrique ou un type de colonne différent du bureau à levage électrique ;
chacune de l'au moins une borne d'acquisition de tension mesurée (105) est adaptée pour être connectée électriquement à une borne de sortie de tension mesurée (107) respective ; et
le microprocesseur (103) est configuré pour déterminer, en fonction d'un signal de tension fourni par chacun de l'au moins un circuit d'acquisition de tension mesurée (104), si l'unité de commande (101) est connectée à au moins l'un respectif parmi le circuit de pilotage de moteur (102) pour déterminer au moins l'un parmi un nombre de colonnes du bureau à levage électrique ou un type de colonne du bureau à levage électrique ; dans lequel
le circuit d'acquisition de tension mesurée (104) comprend une première résistance (R1), une première extrémité de la première résistance (R1) est configurée pour être connectée électriquement à une borne de tension d'alimentation électrique (VCC), et une deuxième extrémité de la première résistance (R1) est connectée électriquement à la fois à la borne d'acquisition de tension mesurée (105) respective et au microprocesseur (103) ;
l'unité de commande (101) comprend en outre une première borne de mise à la terre (11), le circuit de pilotage de moteur (102) comprend en outre une deuxième borne de mise à la terre (12), et la deuxième borne de mise à la terre (12) est connectée à la première borne de mise à la terre (11) ;
le circuit de génération de tension mesurée (106) comprend une deuxième résistance (R2), une première extrémité de la deuxième résistance (R2) est connectée électriquement à la deuxième borne de mise à la terre (12), et une deuxième extrémité de la deuxième résistance R2 est connectée électriquement à la borne de sortie de tension mesurée (107) ; et
une valeur de résistance de la deuxième résistance (R2) correspond à la fois au nombre de colonnes du bureau à levage électrique et au type de colonne du bureau à levage électrique.

2. Système de commande (100) selon la revendication 1, dans lequel le microprocesseur (103) est configuré pour déterminer, en fonction du signal de tension fourni par un circuit d'acquisition de tension mesurée (104), si l'unité de commande (101) est connectée au circuit de pilotage de moteur (102), de la manière suivante :
la comparaison du signal de tension fourni par le circuit d'acquisition de tension mesurée (104) à un signal de tension d'alimentation électrique ;
la détermination que l'unité de commande (101) est déconnectée du circuit de pilotage de moteur (102), lorsque le signal de tension fourni par le circuit d'acquisition de tension mesurée (104) est égal au signal de tension d'alimentation électrique ; et
la détermination que l'unité de commande (101) est connectée au circuit de pilotage de moteur (102), lorsque le signal de tension fourni par le circuit d'acquisition de tension mesurée (104) est inférieur au signal de tension d'alimentation électrique.

3. Système de commande (100) selon la revendication 2, dans lequel le microprocesseur (103) est configuré pour déterminer au moins l'un parmi le nombre de colonnes du bureau à levage électrique ou le type de colonne du bureau à levage électrique, de la manière suivante :
la détermination de la valeur de résistance de la deuxième résistance (R2) en fonction d'une valeur de résistance connue de la première résistance (R1) et d'une formule de calcul de signal de tension que V = VCC*R2/(R1+R2), lorsque le signal de tension fourni par un circuit d'acquisition de tension mesurée (104) est inférieur au signal de tension d'alimentation électrique ; et
la détermination, en fonction d'une correspondance entre la valeur de résistance de la deuxième résistance (R2) et l'au moins l'un parmi le nombre de colonnes ou le type de colonne, de l'au moins l'un parmi le nombre de colonnes du bureau à levage électrique ou le type de colonne du bureau à levage électrique.

4. Système de commande (100) selon l'une des revendications 1 à 3, dans lequel une valeur de résistance de la première résistance (R1) est la même que la valeur de résistance de la deuxième résistance (R2) ou différente de celle-ci.

5. Système de commande (100) selon l'une des revendications 1 à 4, dans lequel la tension d'alimentation électrique VCC est 3,3 V, 5 V ou 12 V.

6. Système de commande (100) selon l'une des revendications 1 à 5, dans lequel le nombre de colonnes est supérieur à zéro ; et le type de colonne comprend une colonne à deux sections et une colonne à trois sections.

7. Système de commande (100) selon l'une des revendications 1 à 6, dans lequel l'unité de commande (101) comprend en outre une borne de tension de rotation avant (M+), une borne de tension de rotation inverse (M-), une borne de signal à effet Hall (HALL) et une borne d'alimentation de signal à effet Hall (VCC_HALL) ; et
la borne de tension de rotation avant (M+) est configurée pour transmettre un signal de rotation avant pour commander un moteur connecté électriquement à un circuit de pilotage de moteur (102) ; la borne de tension de rotation inverse (M-) est configurée pour transmettre un signal de rotation inverse pour commander le moteur connecté électriquement à un circuit de pilotage de moteur (102) ; la borne de signal à effet Hall (HALL) est configurée pour transmettre un signal de position de rotor du moteur ; et
la borne d'alimentation de signal à effet Hall (VCC_HALL) est configurée pour se connecter à un dispositif externe pour alimenter un capteur à effet Hall à l'intérieur du moteur.

8. Bureau à levage électrique (200), comprenant
au moins une colonne ; et
le système de commande (100) selon l'une quelconque des revendications 1 à 7.
